(19) Europäisches Patentamt
European Patent Office
Office européen des brevets

(11) **EP 4 310 527 A1**

(12) **EUROPEAN PATENT APPLICATION**

(43) Date of publication:
**24.01.2024 Bulletin 2024/04**

(21) Application number: **22315165.5**

(22) Date of filing: **22.07.2022**

(51) International Patent Classification (IPC):
**G01R 33/00** $^{(2006.01)}$   **G01R 33/09** $^{(2006.01)}$

(52) Cooperative Patent Classification (CPC):
**G01R 33/0094; G01R 33/0029; G01R 33/09;**
G01R 33/098

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicants:
• CROCUS TECHNOLOGY SA
**38025 Grenoble (FR)**

• **Crocus Technology Inc.
Milpitas, CA 95035 (US)**

(72) Inventors:
• **SERRANO GUISAN, Santiago
San Jose, CA 95120 (US)**
• **MOHAN, Anuraag
Fremont, CA 94536 (US)**

(74) Representative: **P&TS SA (AG, Ltd.)**
**Avenue J.-J. Rousseau 4**
**P.O. Box 2848**
**2001 Neuchâtel (CH)**

(54) **CASCADE MAGNETIC SENSOR CIRCUIT AND A LINEAR MAGNETIC SENSOR DEVICE COMPRISING THE CASCADE MAGNETIC SENSOR CIRCUIT**

(57) The present disclosure concerns a cascade magnetic sensor circuit (100) comprises N magnetic sensors ($2_n$), wherein N equal to or greater than 2, wherein said N magnetic sensors ($2_n$) comprises a first magnetic sensor ($2_1$) and at least another magnetic sensor ($2_n$) electrically connected in cascade with each other. The first magnetic sensor ($2_1$) is configured to generate a first output voltage ($V_{out1}$) dependent on an external magnetic field vector (H) when inputted with an input bias voltage ($V_{dd}$). The output voltage of the $n^{th}$ magnetic sensor is used as input bias voltage of the next (n+1) magnetic sensor. The cascade magnetic sensor circuit can be configured to generate a non-linear output voltage ($V_{outCascade}$) that is proportional to a degree n with respect to the first output voltage ($V_{out1}$). This cascade magnetic sensor circuit (100) can be used to develop high linear magnetic sensor devices (10) either with respect to the magnetic field amplitude or with the magnetic field orientation. This cascade magnetic sensor circuit can also be used to generate any desired polynomial output voltage response.

Fig. 2

EP 4 310 527 A1

**Description**

Technical domain

The present disclosure concerns a cascade magnetic sensor circuit configured to generate a non-linear cascade output voltage. The present disclosure further concerns a magnetic sensor device comprising the cascade magnetic sensor circuit.

Related art

Linear magnetic sensors have many consumer, industrial and automotive applications. Current sensing, positioning, proximity detection, biometric sensing are some examples. Sensor technologies using Magnetic Tunnel Junctions (MTJs) based on Tunnel Magneto-Resistance (TMR) effect excel among rival technologies based on Anisotropic Magneto-Resistance (AMR) effect, Giant Magneto-Resistance (GMR) effect and Hall effect, thanks to their higher sensitivity and signal-to-noise ratio (SNR), lower temperature dependence, better long-term stability, and generally smaller die size.

Commonly, such sensors provide an output voltage $V_{out}$ that is roughly proportional to external applied magnetic field H. However, the larger the magnetic field is, the larger is the deviation of $V_{out}$ from a perfect linear response.

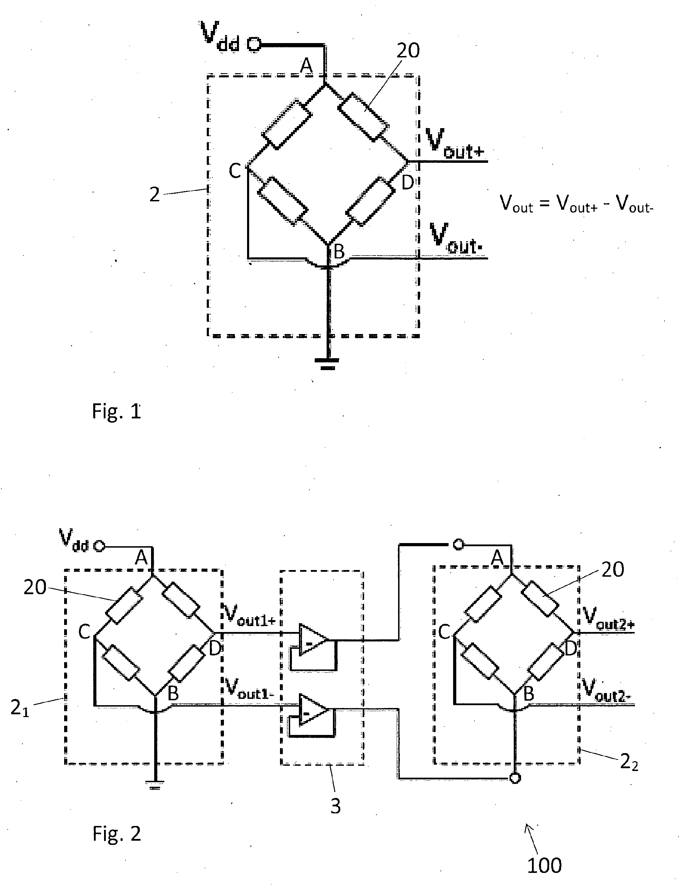

Fig. 1 shows a magnetic sensor 2 comprising four magnetic sensing elements 20 arranged in a full-bridge circuit, such as a Wheatstone bridge circuit. The magnetic sensing element 20 can comprise a magnetoresistive element, such as a magnetic tunnel junction. The differential output voltage $V_{out}$ ($V_{out} = V_{out+} - V_{out-}$) response under an external magnetic field vector H can be approximated to equation 1:

$$V_{out} \sim [\, a_0 + a_1 \cdot H - a_3 \cdot H^3 \,] \cdot V_{dd} \qquad\qquad \text{Eq. 1}$$

where $a_0$ is the sensor offset, $a_1$, and $a_3$ are the linear and 3rd order coefficients, respectively, and $V_{dd}$ is the input bias voltage. Eq. 1 can be rewritten as:

$$V_{out} \sim v_s(H) \cdot V_{dd} \qquad\qquad \text{Eq.2a;}$$

where $v_s$ expresses the intrinsic dependence of the magnetic sensor when submitted to an external magnetic field (for example, $v_s$ does not depend on $V_{dd}$) (i.e., the normalized output voltage of the sensor):

$$v_s(H) = [\, a_0 + a_1 \cdot H - a_3 \cdot H^3 \,] \qquad\qquad \text{Eq.2b.}$$

Usually $a_1 \gg a_3$, which implies that output voltage $V_{out}$ is, substantially linear with the applied field proportional to the input bias voltage $V_{dd}$.

The linearity of such magnetic sensors can generally be improved by the development of a magnetoresistive element, such as a magnetic tunnel junction, that ensures a linear $V_{out}$ response and larger working magnetic field ranges. However, the improvement in linearity of the magnetoresistive element usually comes at the expense of a reduction of sensor sensitivity and magnetic field resolution.

Improving the linearity of the magnetic sensor without reduction of sensitivity has been proposed relying on the implementation of an integrated circuit (IC) configured to correct the non-linearities and obtain a high linear corrected output voltage $V_{corr}$. International patent application number WO2021IB60743 by the present applicant describes a continuous compensation of next high order harmonic component of $V_{out}$ by the implementation of an IC configured to generate a high non-linear voltage that continuously compensates the next high order harmonic component of $V_{out}$. Usually, the more complex is the IC the more linear is the corrected output voltage $V_{corr}$, but at the expense of being more limited to work at high frequencies.

Other solutions can include using a lookup table or calculating a correction polynomial. Such solutions require the use of ADCs, DACs, memory, and a microcontroller and involve full digital reconstruction of $V_{corr}$, usually with high power consumption, lower speed and large die area.

Summary

The present disclosure concerns a cascade magnetic sensor circuit comprising N magnetic sensors, wherein N equal to or greater than 2, wherein each magnetic sensor outputs an output voltage $V_{outn}$, the magnetic sensors being electrically connected in cascade with each other, wherein the output voltage $V_{outn}$ of the $n^{th}$ magnetic sensor of the cascade magnetic sensor circuit supplies the input bias voltage $V_{dd\_n+1}$ of the next magnetic sensor $(n+1)^{th}$:

$$V_{outn} = V_{dd\_(n+1)};$$

and

wherein the output voltage of the $n^{th}$ magnetic sensor $V_{outn}$ is proportional to the input bias voltage $V_{dd\_n}$ inputted to the $n^{th}$ magnetic sensor and to a normalized output voltage $v_{s\_n}$ of the $n^{th}$ magnetic sensor depending on an external magnetic field vector H:

$$V_{outn} = v_{s\_n}(H) \cdot V_{dd\_n};$$

wherein the normalized output voltage $v_{s\_n}$ expresses the intrinsic dependence of the magnetic sensor when submitted to the external magnetic field vector.

In an embodiment, the cascade sensor circuit is configured to generate a cascade output voltage:

$$V_{outCascade} = V_{dd} \cdot \prod_{n=1}^{N} v_{s\_n},$$

where $V_{outCascade}$ is the cascade output voltage and $V_{dd}$ is the bias voltage applied to the first magnetic sensor of the cascade magnetic sensor circuit.

In another embodiment, the cascade sensor circuit is configured to generate a cascade output voltage determined by:

$$V_{outCascade} = \sum_{n=1}^{N} a_n \cdot V_{outn},$$

where the $V_{outn}$ is the voltage output of the $n^{th}$ magnetic sensor and $a_n$ coefficient is independent of the external magnetic field vector and can be either positive or negative.

The cascade sensor circuit can be configured to correct high order components of a first output voltage $V_{out1}$ of the first magnetic sensor of the N magnetic sensors, and/or generate any desired polynomial output voltage response.

The present disclosure further concerns a magnetic sensor device for sensing an external magnetic field vector H and comprising the cascade magnetic sensor circuit. The magnetic sensor device is configured to output a corrected output voltage $V_{corr}$ of the magnetic sensor device that is determined by:

$$V_{corr} = a \cdot V_{outRef} + b \cdot V_{outCascade},$$

where $V_{outRef}$ is typically the output voltage of a magnetic sensor used as reference and the coefficients a and b are independent of the external magnetic field vector H.

The magnetic sensor device outputs a corrected output voltage having improved linearity with magnetic field amplitude and/or magnetic field orientation compared to the reference output voltage.

The magnetic sensor device can provide a linear signal without relying on CMOS processing, analog IC development, implementation and/or IC trimming. Instead, the cascade sensor compensates the non-linear coefficients of the output voltage of the magnetic sensor device, ensuring a linear magnetic sensor device with higher bandwidth operation

The magnetic sensor device can correct the output voltage for higher order components, such as 5th order and beyond to increase the magnetic field range operation or improve linearity. The magnetic sensor device has an improved linearity as a function of temperature and is compatible with a correction of the temperature coefficient of sensitivity.

The cascade sensor circuit can be configured to linearize and angular magnetic sensor therefore the magnetic sensor device has an improved linearity with respect to the orientation of the magnetic field, improving the working angular range of angular magnetic sensors for auto-focus (AF) applications.

Short description of the drawings

Exemplar embodiments of the invention are disclosed in the description and illustrated by the drawings in which:

Fig. 1 illustrates a magnetic sensor comprising four magnetic sensing elements arranged in a full-bridge circuit;

Fig. 2 shows a cascade sensor circuit, according to an embodiment;

Fig. 3 shows a cascade sensor device comprising three magnetic sensors, according to an embodiment;

Fig. 4 shows a general configuration of the cascade magnetic sensor circuit comprising N magnetic sensors, according to an embodiment;

Fig. 5 illustrates a magnetic sensor device for sensing an external magnetic field vector and comprises the cascade magnetic sensor circuit, according to an embodiment;

Fig. 6 shows a generic representation of the magnetic sensor device 10, according to an embodiment;

Fig. 7 illustrates an example of the magnetic sensor device of Fig. 6;

Fig. 8 shows the cascade output voltage of the cascade sensing circuit as a function of the reference output voltage for the magnetic sensor device of Fig. 5;

Fig. 8a shows the dependence of the linearity error of the corrected output voltage as a function of the bias voltage of the cascade sensing circuit;

Fig. 9a shows the reference output voltage $V_{outRef}$ of a reference magnetic sensor as well as the corrected output voltage $V_{corr}$ of the magnetic sensor device of Fig.5 as a function of the applied magnetic field, when submitted to a bias voltage of 1V;

Fig. 9b show the linearity error of both the reference output voltage $V_{outRef}$ of the reference magnetic sensor as well as the corrected output voltage $V_{corr}$ of the magnetic sensor device of Fig.5

Fig. 10a shows the dependence of the linearity error of the corrected output voltage of the magnetic sensor device of Fig. 7 as a function of the bias voltage of the cascade sensing circuit $V_0$ when the bias voltage of the reference magnetic sensor $V_{dd}$ equals 1V;

Fig. 10b shows the experimentally determined bias voltage of the cascade sensing circuit $V_0$ necessary to obtain the lowest linearity error of the corrected output voltage of the magnetic sensor device of Fig.7 when the reference magnetic sensor is biased by 1V;

Figs. 11a and 11b show the sensitivity (Fig. 11a) and linearity error (Fig. 11b) of the reference output voltage of the reference magnetic sensor ($V_{outRef}$) and the corrected output voltage of the magnetic sensor device of Fig. 7 as a function of temperature;

Figs 12a report the third order coefficient as a function of temperature;

Fig. 12b shows a variation of the bias voltage of the cascade sensing circuit $V_0$ of the magnetic sensor device of Fig.7 such that the linearity error is smaller than 0.08% at all temperature range;

Fig. 13 illustrates a 2D magnetic sensor device, according to an embodiment;

Fig. 14 shows the corrected output voltage (Fig. 14a), the reference output voltage (Fig. 14b) and the linearity error (Fig. 14c) with respect to the magnetic field orientation of the 2D magnetic sensor device of Fig.13;

Fig. 15 illustrates a 2D magnetic sensor device, according to another embodiment;

Fig. 16 illustrates a cascade sensor circuit for generating a polynomial output voltage response, according to another embodiment.

Examples of embodiments

Fig. 2 illustrates a cascade magnetic sensor circuit 100 according to an embodiment. The cascade magnetic sensor circuit 100 is shown comprising two magnetic sensors ($2_{n=1}$, $2_{n=2}$ or $2_1$, $2_2$) electrically connected in cascade with each other.

It should be understood that the cascade magnetic sensor circuit 100 can comprise more than two magnetic sensors. More generally, the cascade magnetic sensor circuit 100 can comprise N magnetic sensors $2n$, wherein N equal to or greater than 2, where the magnetic sensors $2n$ are electrically connected in cascade with each other. The output voltage $V_{out}$ of the $n^{th}$ magnetic sensor of the cascade magnetic sensor circuit $2_n$ (with $n \leq N$) is proportional to the input bias voltage $V_{dd\_n}$ of the $n^{th}$ magnetic sensor $2_n$ and to the normalized output voltage $v_{s\_n}$ of the magnetic sensor $2_n$ depending on the external magnetic field vector H, as defined by equation 3:

$$V_{outn} = v_{s\_n}(H) \cdot V_{dd\_n} \qquad\qquad \text{Eq. 3,}$$

where $v_{s\_n}$ can be defined by equation 2b.

The output voltage $V_{outn}$ of the $n^{th}$ magnetic sensor $2_n$ supplies the input bias voltage $V_{dd\_n+1}$ of the next magnetic sensor $2_{n+1}$. The cascade sensor circuit 100 generates therefore an output voltage $V_{outCascade}$, as defined by equation 4:

$$V_{outCascade} = V_{dd} \cdot \prod_{n=1}^{N} v_{s\_n} \qquad\qquad \text{Eq. 4,}$$

where $V_{dd}$ is the input bias voltage of the first magnetic sensor of the cascade sensor circuit.

In reference with Fig. 2, the cascade magnetic sensor circuit 100 comprises two magnetic sensor $2_n$, including a first magnetic sensor $2_1$, the two magnetic sensor $2_n$ are electrically connected in cascade. The first magnetic sensor $2_1$ is configured to generate a first output voltage $V_{out\_1}$ dependent on the external magnetic field vector H as described by equation 3.

The normalized output voltage $v_{s\_n}$ (H) of the second magnetic sensor $2_n$ can have a substantially identical dependence on the external magnetic field vector H as the normalized output voltage $v_s$(H) of the first magnetic sensor $2_1$. Therefore, the output voltage $V_{outn}$ of the second magnetic sensor $2_n$ is proportional to a degree n (here n= 2) with respect to the first output voltage $V_{out1}$ of the first magnetic sensor $2_1$. In this embodiment, the cascade magnetic sensor circuit 100 outputs a cascade output voltage $V_{outCascade}$ that corresponds to the output voltage $V_{outn}$ of the second magnetic sensor $2_n$.

The first magnetic sensor $2_1$ and the second magnetic sensor $2_n$ can comprise four magnetic sensing elements 20 arranged in a full-bridge circuit, such as a Wheatstone bridge circuit. The magnetic sensing element 20 can comprise a magnetoresistive element, such as a magnetic tunnel junction. The first magnetic sensor $2_1$ is electrically connected in cascade with the second magnetic sensor $2_n$ such that the first differential output voltages $V_{out1+}$ and $V_{out1-}$ of the first magnetic sensor $2_1$ (nodes C and D) are respectively connected to the bias inputs (nodes A and B) of the second magnetic sensor $2_n$.

The first output voltage $V_{out1}$ is a differential output voltage that is equal to the difference between $V_{out1+}$ and $V_{out1-}$ of the full-bridge circuit. The first output voltage $V_{out1}$ follows equations 2a, 2b and 3. When subjected to an external applied magnetic field H, the first magnetic sensor $2_1$ produces the first output voltage $V_{out1}$ between points C and D and can be expressed by equation 4b:

$$V_{out\_1} = V_{out1+} - V_{out1-} = V_{dd} \cdot v_{s\_1}(H) \qquad \text{Eq. 4b,}$$

where $V_{dd}$ is the bias voltage applied to the first magnetic sensor $2_1$ and $v_{s\_1}(H)$ is the normalized output voltage of the first magnetic sensor $2_1$ (described by Eq. 2b).

The second output voltage $V_{outn}$, where n=2, of the second magnetic sensor $2_n$ can be expressed by equation 5a:

$$V_{out2} = V_{out2} - V_{out} = V_{dd2} \cdot v_{s\_2}(H) \qquad \text{Eq. 5a,}$$

where $V_{dd\_2}$ and $v_{s\_2}(H)$ are the input bias voltage and the normalized output voltage of the second magnetic sensor $2_2$ respectively. However, in this cascade configuration, the output voltage $V_{out1}$ of the first magnetic sensor $2_1$ is used as input bias voltage of the second magnetic sensor $2_n$ ($V_{ddn}$). Therefore:

$$V_{out\ 2} = V_{out\ 1} \cdot v_{s\ 2}(H) = V_{dd} \cdot v_{s\_1}(H) \cdot v_{s\_2}(H) \qquad \text{Eq. 5b.}$$

If the second magnetic sensor $2_2$ is configured to have a similar magnetic field vector dependence than the one of the first magnetic sensor $2_1$ ($v_{s\_2} = v_{s\_1}$), then:

$$V_{out2} = V_{dd} \cdot v_{s\_1}^2(H) \sim V_{dd} \cdot [a_0 + a_1 \cdot H - a_3 \cdot H^3]^2 \qquad \text{Eq. 6a.}$$

or:

$$V_{out2} = V_{dd} \cdot \left( \frac{V_{out1}^2}{V_{dd}^2} \right) = V_{out\ 1}^2 / V_{dd} \qquad \text{Eq. 6b.}$$

As equation 6b shows, the differential output voltage $V_{out2}$ of the second magnetic sensor $2_2$ is quadratic with respect to the first output voltage $V_{out1}$ of the first magnetic sensor $2_1$ in case that both magnetic sensors have a similar magnetic field dependence.

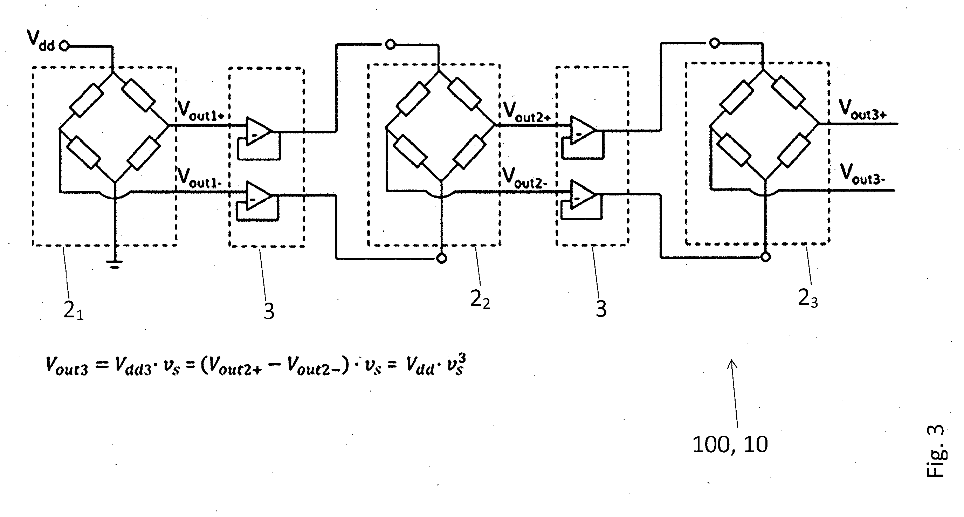

Fig. 3 shows the cascade sensor device 100 comprising three magnetic sensors $2_n$ (N=3), in particular a first magnetic sensor $2_1$ and two other magnetic sensors $2_2$ and $2_3$. The three magnetic sensors are electrically connected in cascade with each other. The differential output voltages $V_{outn+}$ and $V_{outn-}$ of the n$^{th}$ magnetic sensor $2_n$ can be respectively connected to the bias input of the following magnetic sensor (n+1) $2_{n+1}$. In this configuration, output voltage $V_{out3}$ of the third magnetic sensor $2_3$ can be expressed by equation 7:

$$V_{out3} = V_{out2} \cdot v_{s\_3}(H) = V_{out1} \cdot v_{s\_2}(H) \cdot v_{s\ 3}(H) = V_{dd} \cdot v_{s\_1\ 1}(H) \cdot v_{s\_2}(H) \cdot$$
$$v_{s\_3}(H) \qquad \text{Eq. 7.}$$

The three magnetic sensors 2n can have a substantially identical dependence on the external magnetic field vector H ($v_{s\_1}(H) = v_{s\_2}(H) = v_{s\_3}(H)$). For this configuration, the output voltage $V_{out3}$ of the third magnetic sensor can be expressed by equation 8a:

$$V_{out3} = V_{dd} \cdot v^3_{s\_1 \ 1}(H) \sim V_{dd} \cdot [ \, a_0 + a_1 \cdot H - a_3 \cdot H^3]^3 \qquad \text{Eq. 8a.}$$

Equation 8a can also be rewritten as:

$$V_{out3} = V_{dd} \cdot \left(\frac{V^3_{out1}}{V^3_{dd}}\right) = V^3_{out1}/V^2_{dd} \qquad \text{Eq. 8b.}$$

As shown in Eq. 8b, the output voltage $V_{out3}$ of the third magnetic sensor $2_3$ is cubic with respect to the first output voltage $V_{out1}$ in case that the three magnetic sensors have a similar magnetic field dependence.

Therefore, for this configuration (Fig. 3) the cascade magnetic sensor circuit 100 outputs a cascade output voltage $V_{outCascade}$ that corresponds to the output voltage of the third magnetic sensor $2_3$.

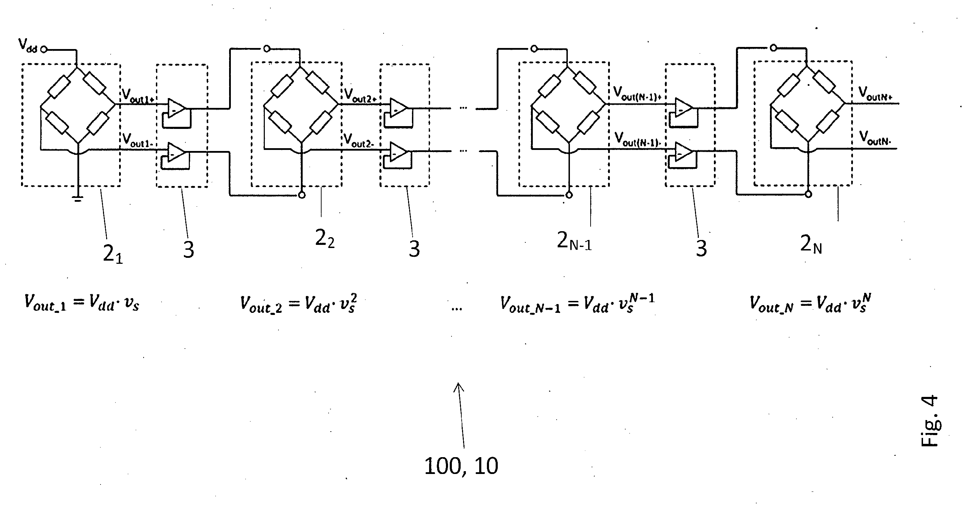

Fig. 4.shows a more general configuration of the cascade magnetic sensor circuit 100 comprising a plurality of (here, more than three) magnetic sensors $2_n$ electrically connected in cascade with each other. Here, the cascade magnetic sensor circuit 100 comprises N magnetic sensors $2_n$, where N > 3.

In this configuration, the cascade magnetic sensor circuit 100 outputs a cascade output voltage $V_{outCascade}$ that corresponds to the output voltage $V_{outN}$ of the $N^{th}$ magnetic sensor $2_N$ and is described by equation 4.

In the case that all the N magnetic sensors $2_n$ of the cascade sensing circuit 100 have a substantially identical magnetic field vector dependence ($v_{s\_1}(H) = v_{s\_2}(H) =...= v_{s\_N}(H)$), then:

$$V_{outCascade} = V_{dd} \cdot v^N_{s\_1 \ 1}(H) \sim V_{dd} \cdot [ \, a_0 + a_1 \cdot H - a_3 \cdot H^3]^N \quad \text{Eq. 9a.}$$

Equation 9a can also be rewritten as:

$$V_{outCascade} = V_{dd} \cdot \left(\frac{V^N_{out1}}{V^N_{dd}}\right) = V^N_{out1}/V^{N-1}_{dd} \qquad \text{Eq. 9b}$$

In this configuration, each $n^{th}$ stage of the cascade sensing circuit 100 generates an output voltage $V_{outn}$ that is proportional to the $n^{th}$ power of the first output voltage $V_{out1}$ of the first magnetic sensor $2_1$ of the cascade sensing circuit 100.

Referring again to Fig. 2, the cascade sensor circuit 100 comprises an amplifier buffer 3 electrically connected between the differential output voltages $V_{out1+}$ and $V_{out1-}$ (points C and D) of the first magnetic sensor $2_1$ and the bias inputs (points A and B) of the magnetic sensor $2_n$. Referring to Figs. 3 and 4, the cascade sensor circuit 100 can further comprise an amplifier buffer 3 between the n-1 output voltage $V_{outn-1}$ of the n-1 magnetic sensor $2_{n-1}$ and the input of the n magnetic sensor $2_n$. The amplifier buffer 3 prevents the input impedance of a magnetic sensor $2_n$ from loading the output impedance of the previous magnetic sensor $2_{n-1}$, which would cause undesirable loss of signal transfer.

Similar to the cascade magnetic sensor circuit 100 shown in Figs 2 and 3, the magnetic sensors $2_n$ of the cascade magnetic sensor circuit 100 of Fig. 4 can comprise four magnetic sensing elements 20 arranged in a full-bridge circuit, such as a Wheatstone bridge circuit. The magnetic sensing element 20 can comprise a magnetoresistive element, such as a magnetic tunnel junction. For example, the magnetic sensing element 20 can comprise a magnetic tunnel junction comprising a reference layer having a reference magnetization and a sense layer having a sense magnetization that can be oriented relative to the reference magnetization, according to the orientation of the external magnetic field H.

The presented cascade magnetic sensor circuit 100 can be configured to improve the linearity of a magnetic sensor device for sensing the external magnetic field vector H.

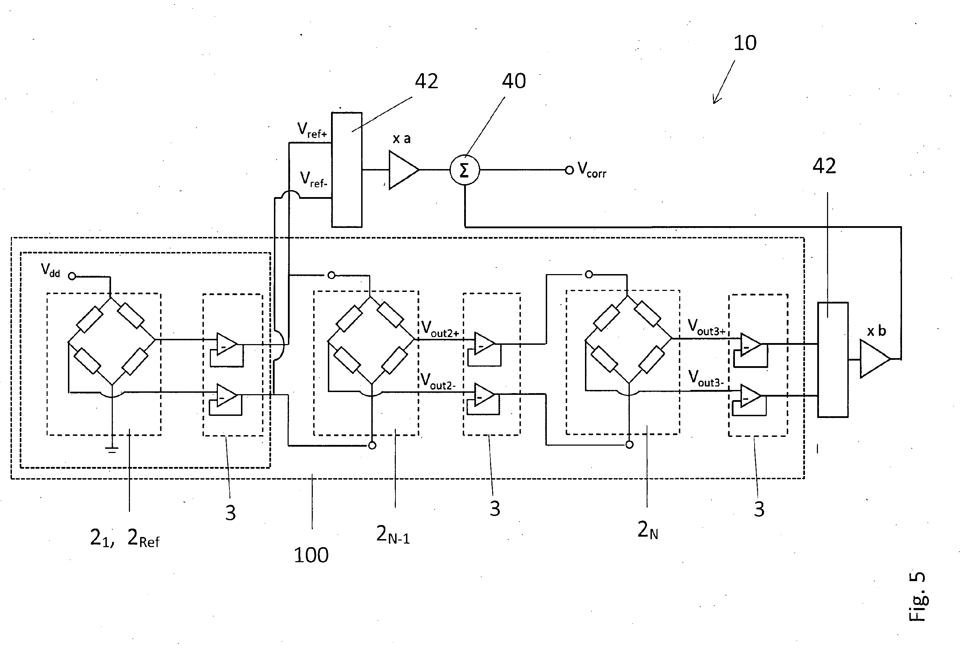

In an embodiment illustrated in Fig. 5, a magnetic sensor device 10 for sensing an external magnetic field vector H comprises the cascade magnetic sensor circuit 100 including three magnetic sensors 2n (N = 3) connected in cascade. The output voltage $V_{out3}$ of the third magnetic sensor $2_3$ can be used to compensate the non-linearity of the output voltage $V_{out1}$ of the first magnetic sensor $2_1$. The output voltage $V_{out1}$ (differential output voltages $V_{out1+}$ and $V_{out1-}$) of the first magnetic sensors $2_1$ is summed to the output voltage $V_{out3}$ (differential output voltages $V_{out3+}$ and $V_{out3-}$) of the third magnetic sensor $2_3$ by a summing circuit 40. Each of the output voltages $V_{out1}$ and $V_{out3}$ can be electrically connected to a differential amplifier 42. In the case the three magnetic sensors 2n have a substantially identical dependence on the external magnetic field vector H, the corrected output voltage $V_{corr}$ of the magnetic sensor device 10 shown in Fig.

5 can be determined by equation 10:

$$V_{corr} = a \cdot V_{out} + b \cdot V_{out3} \qquad \text{Eq. 10,}$$

where a and b are correction parameters independent of the external magnetic field vector H. By adjusting the values of a and b, the corrected output voltage $V_{corr}$ of the magnetic sensor device 10 shows an improved linearity compared to the first output voltage $V_{out1}$ of the first magnetic sensor $2_1$.

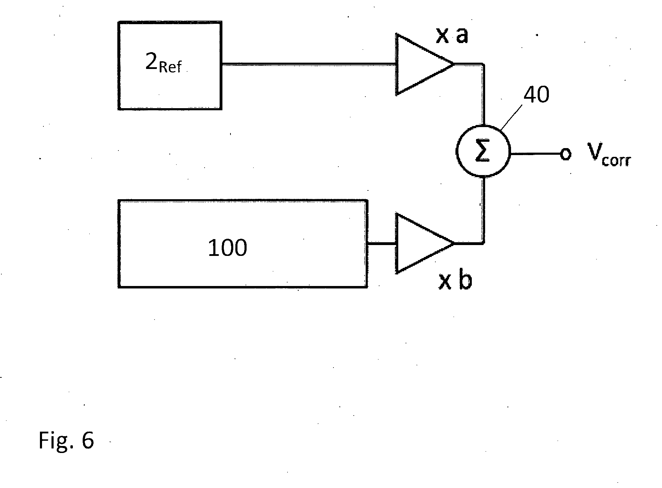

In one aspect, the cascade magnetic sensor circuit 100 can further comprise an amplifier buffer at the output of each magnetic sensor of the cascade magnetic circuit 100. Fig. 6 shows a generic representation of the magnetic sensor device 10, according to an embodiment. The magnetic sensor device 10 comprises a cascade sensing circuit 100 and a reference magnetic sensor $2_{Ref}$ configured to generate a reference output voltage $V_{outRef}$ dependent on the external magnetic field vector H such that the corrected output voltage $V_{corr}$ of the magnetic sensor device 10 is determined by:

$$V_{corr} = a \cdot V_{outRef} + b \cdot V_{outCascade} \qquad \text{Eq. 11.}$$

Note that for such a configuration, the reference magnetic sensor is biased by a voltage $V_{dd}$ and the cascade sensing circuit 100 is biased by a voltage $V_0$.

In the configurations of Figs. 1 to 5, the first magnetic sensor $2_1$ can play the role of a reference magnetic sensor $2_{Ref}$ and the reference magnetic sensor and the cascade sensing circuit are biased by the same bias voltage ($V_0 = V_{dd}$). In the configuration of Fig. 6, the reference magnetic sensor $2_{Ref}$ is arranged separately from the cascade sensing circuit 100. The reference output voltage $V_{outRef}$ of the reference magnetic sensors $2_{Ref}$ is summed to the cascade output voltage $V_{outCascade}$ of the cascade sensing circuit 100 by a summing circuit 40.

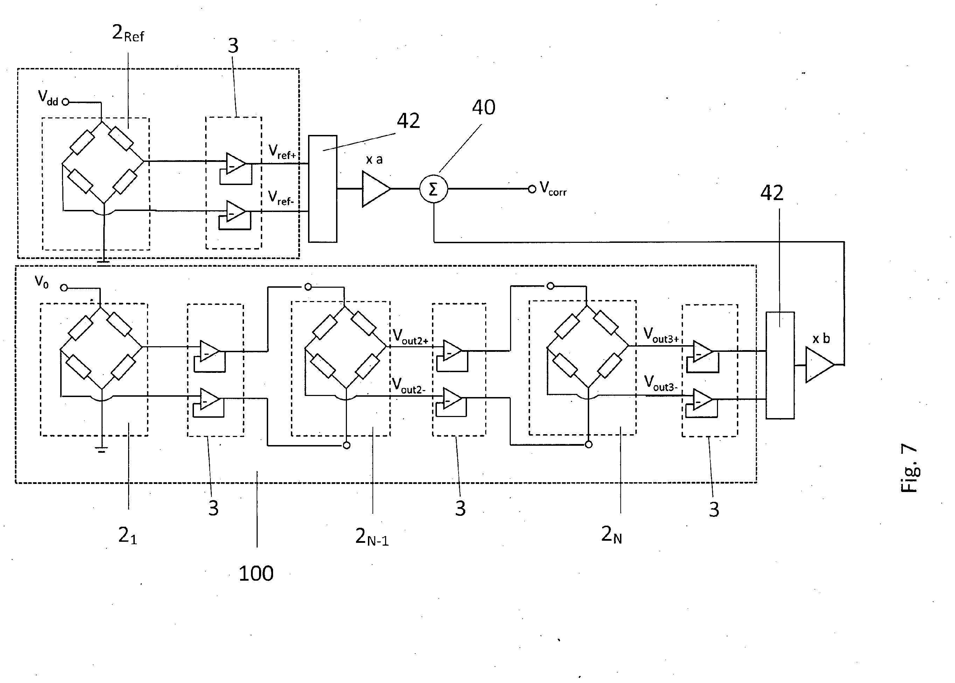

Fig. 7 illustrates an example of the magnetic sensor device 10 of Fig. 6, where the cascade sensing circuit 100 comprises three magnetic sensors 2n. Each of the three magnetic sensors 2n and the reference magnetic sensor $2_{Ref}$ comprises four magnetic sensing elements 20 arranged in a full-bridge circuit, such as a Wheatstone bridge circuit. The magnetic sensing element 20 can comprise a magnetoresistive element, such as a magnetic tunnel junction. The reference magnetic sensor $2_{Ref}$ can be inputted by an input bias voltage $V_{dd}$ such that the reference magnetic sensor $2_{Ref}$ generates the first reference output voltage $V_{outRef}$ dependent on the external magnetic field vector H. Because the response of the cascade sensing circuit 100 is proportional to the input bias voltage of the first magnetic sensor $2_1$ of the cascade sensing circuit, the input bias voltage of the first magnetic sensor $2_1$ of the cascade sensing circuit 100 can be referred to as the bias voltage of the cascade sensing circuit. The cascade sensing circuit 100 can be biased with an input bias voltage $V_0$ such that the cascade sensing circuit 100 generates the cascade output voltage $V_{outCascade}$. Similar to the cascade sensing circuit 100 shown in Fig. 5, the cascade output voltage $V_{outCascade}$ is generated by the output voltage $V_{out3}$ of the third (or last) magnetic sensor $2_3$ of the cascade sensing circuit 100. The reference output voltage $V_{outRef}$ of the reference magnetic sensor $2_{Ref}$ is electrically connected to cascade output voltage $V_{outCascade}$ via a summing circuit 40. Each of the output voltages, the cascade output voltage $V_{outCascade}$ of the cascade sensing circuit 100, as well as the reference output voltage $V_{outRef}$ of the reference magnetic sensor $2_{Ref}$, can be electrically connected to a differential amplifier 42.

In one aspect, the magnetic sensor device 10 can further comprise an amplifier buffer 3 at the output of each magnetic sensor of the magnetic sensor device.

In the case the magnetic sensing element 20 comprises a magnetic tunnel junction element and the reference magnetic sensor $2_{Ref}$ is biased at $V_{dd}$, the reference output voltage $V_{outRef}$ can be expressed by equation 12:

$$V_{outRef} = V_{dd} \cdot v_{s\_Ref}(H) \sim V_{dd} \cdot [\, a_0 + a_1 \cdot H - a_3 \cdot H^3 \,] \qquad \text{Eq. 12.}$$

In the case where the magnetic sensors $2_n$ of the magnetic sensor circuit 100 have a similar magnetic field vector dependence than the reference magnetic sensor the cascade output voltage $V_{outCascade}$ can be expressed by equation 13:

$$V_{outCascade} = \dot{V_0} \cdot v_{s\_Ref}(H)^3 \sim V_0 \cdot [\, a_0 + a_1 \cdot H - a_3 \cdot H^3]^3 \qquad \text{Eq. 13.}$$

By summing the reference output voltage $V_{outRef}$ to the cascade output voltage $V_{outCascade}$, a corrected output voltage $V_{corr}$ is obtained:

$$V_{corr} = V_{outRef} + V_{outCascade} = V_{dd} \cdot \left[ v_{s\_Ref}(H) + \frac{V_0}{V_{dd}} \cdot v_{s\_Ref}(H)^3 \right] \quad \text{Eq. 14.}$$

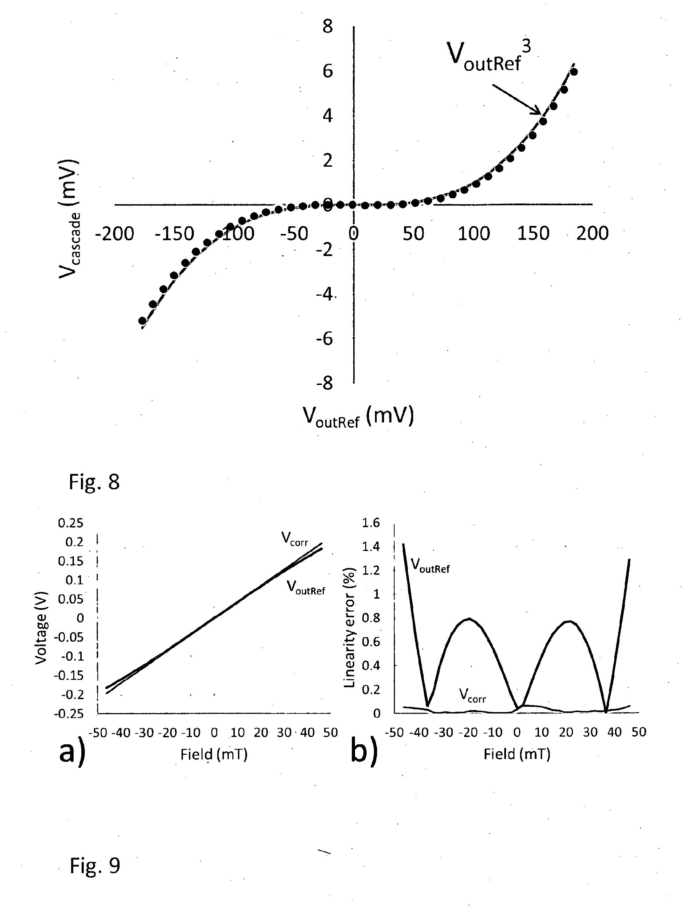

Fig. 8 shows the cascade output voltage $V_{outCascade}$ of the cascade sensing circuit 100 as a function of the reference output voltage $V_{outRef}$ for the magnetic sensor device 10 of Fig. 5, when the input bias voltage $V_{dd}$ applied at the reference magnetic sensor $2_{Ref}$ and the input bias voltage $V_0$ applied at the cascade sensing circuit 100 are $V_{dd} = V_0 = 1V$. The output voltage generated by the cascade sensing circuit 100 $V_{outCascade}$ (points) follows closely the cube of the reference output voltage $V_{outRef}$ (continuous grey line) as expected by Eq. 8b. Fig. 8 shows therefore that the cascade sensing circuit 100 can provide a non-linear response that can be used to compensate the non-linearity of other voltage signals.

Fig. 9a shows the reference output voltage $V_{outRef}$ (black curve) of the reference magnetic sensor $2_{Ref}$ as a function of the applied magnetic field H, when submitted to an input bias voltage $V_{dd}$ of 1V. The linearity error of the reference magnetic sensor $2_{Ref}$ when submitted at magnetic fields up to $\pm 47$ mT is $\sim 1.4\%$ (curve $V_{outRef}$ on Fig.9 b). On the other hand, the corrected output voltage $V_{corr}$ of a magnetic device 10 considering the same reference magnetic sensor biased by $V_{dd} = 1V$ and a cascade sensing circuit 100 formed by three magnetic sensors $2_n$ (as sketched in Fig. 7) when the cascade sensing circuit is biased at $V_0 = 2.4V$ is shown by the grey curve on Fig.9a. The linearity error of the corrected output voltage $V_{corr}$ is $\sim 0.06\%$ (curve $V_{corr}$ in Fig. 9b) leading to a total reduction of linearity error of about 20 times.

In order to ensure a high linear response of the magnetic sensor device 10, the bias voltage applied to the cascade magnetic sensor circuit 100 ($V_0$) must be proportional to the bias voltage applied to the reference magnetic sensor ($V_{dd}$), as shown by Eq. 15:

$$V_0 = K(a_1, a_3) \cdot V_{dd} \qquad \text{Eq. 15,}$$

where K is a coefficient depending on the linear and third-order coefficients, $a_1$ and $a_3$ respectively, of the reference magnetic sensor response, as described by Eq. 2b.

From the reference output voltage $V_{outRef}$ versus the applied magnetic field H curve of Fig.9a, the following values can be derived: $a_1 \sim 4.24$ mV/V/mT and $a_3 \sim 1.4276$ mVN/mT$^3$. Thus, according to equation 15, the ratio $V_0/V_{dd}$ must be close to 2.17 for an optimal linear response of the magnetic sensor device 10 of Fig. 5, in good concordance with the obtained ratio of 2.4.

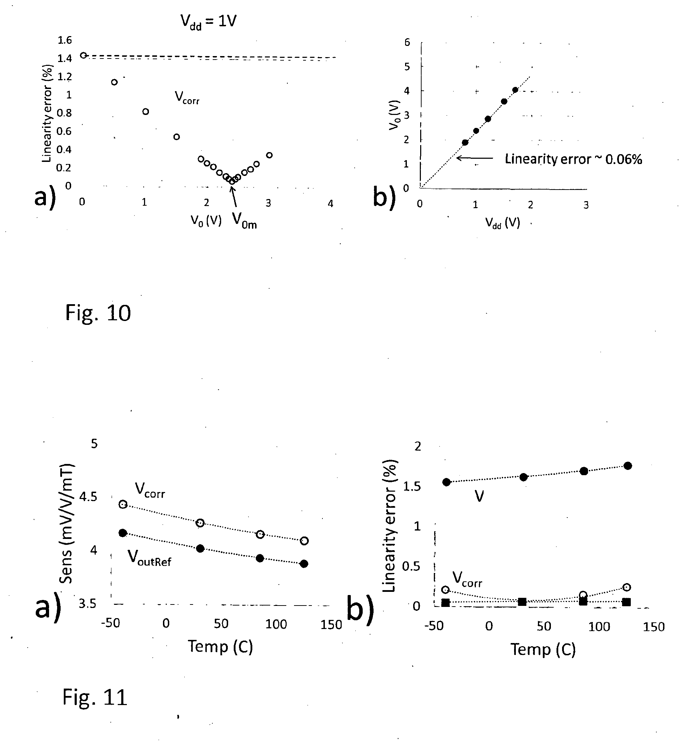

Fig. 10a shows the dependence of the linearity error of the corrected output voltage $V_{corr}$ as a function of the input bias voltage $V_0$ when the input bias voltage $V_{dd}$ equal 1V. The linearity error is minimum ($\sim 0.06\%$) at $V_0 = V_{0m} = 2.4V$ and increases almost linearly with $[V_0 - V_{0m}]$.

Fig. 10b shows the experimentally determined input bias voltage $V_0$ of the cascade sensing circuit 100 necessary to obtain the lowest linearity error ($\sim 0.06\%$) of the corrected output voltage $V_{corr}$ of the reference magnetic sensor $2_{Ref}$ when the reference magnetic sensor $2_{Ref}$ is biased at $V_{dd}$. The ratio $V_0/V_{dd}$ is the same for the four measured points of experimentally determined input bias voltage $V_0$, as predicted by equation 15.

The robustness of the linear response of the magnetic sensor device 10 of Fig. 7 as a function of temperature was evaluated. The response of the magnetic sensor device 10 for an applied magnetic field H of up to $\pm 50$ mT at -40°C, 30°C, 85°C and 125°C was measured.

Figs. 11a and 11b show the sensitivity (Fig. 11a) and linearity error (Fig. 11b) of the reference magnetic sensor $2_{Ref}$ of the magnetic sensor device 10 of Fig. 7 as a function of temperature (black dots). The temperature coefficient of sensitivity (TCS) is equal to about -420 ppm/C and the linearity error is between 1.56% - 1.78% through all the temperature range. Similarly, the sensitivity and linearity error of the temperature dependence of the corrected output voltage $V_{corr}$ from the magnetic sensor device 10 (see Fig. 7) is also plotted (open dots, showing a similar TCS of about -460 ppm/C and a linearity error between 0.06% and 0.25%. The input bias voltage $V_0$ was kept constant ($V_0 \sim 2.4V$) at all temperature ranges.

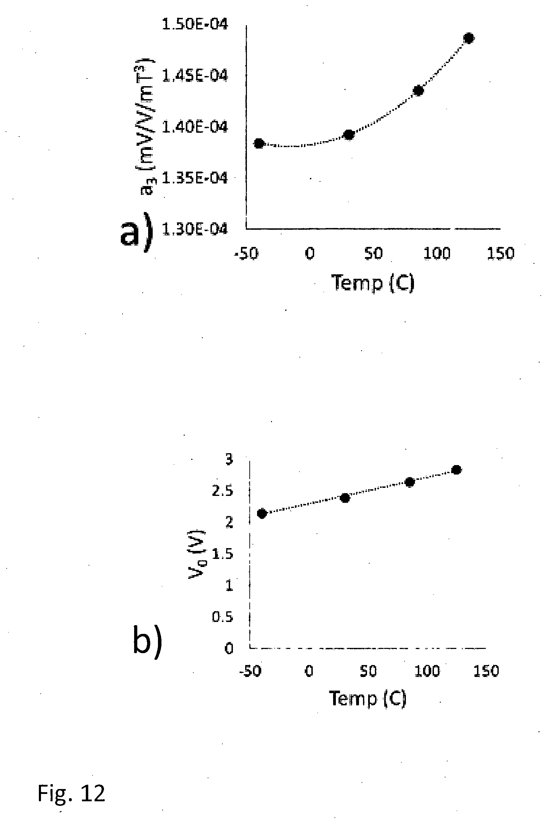

As shown in Figs 12a, the third order coefficient $a_3$ is also temperature dependent. This implies that in order to fully optimize the linearity error of the magnetic sensor device 10, the input bias voltage $V_0$ should be varied over temperature. Fig. 12b shows a possible variation of the input bias voltage $V_0$ such that the linearity error is smaller than 0.08% at all temperature range (see square dots in Fig.11b). However, reasonable linearity error (< 0.3%) is obtained when keeping $V_0$ constant over temperature.

The linear dependence of $V_0$ with temperature highlights the possibility to contemplate a correction temperature such that the magnetic sensor device 10 has a low TCS, for example a TCS smaller than -100 ppm/C, a linearity error smaller than 0.1 % over the whole temperature range, and a sensitivity greater than 4 mV/V/mT for an applied magnetic field H up to 50 mT.

The cascade magnetic sensor circuit 100 and the magnetic sensor device 10 can also be implemented in 2D magnetic sensors (magnetic sensors sensitive to the orientation of the external magnetic field) or also called angular magnetic sensors to linearize its sinusoidal response. Such implementation can improve the working angular range of the 2D magnetic sensor for auto-focus (AF) applications or for developing a full analog 2D linear sensor.

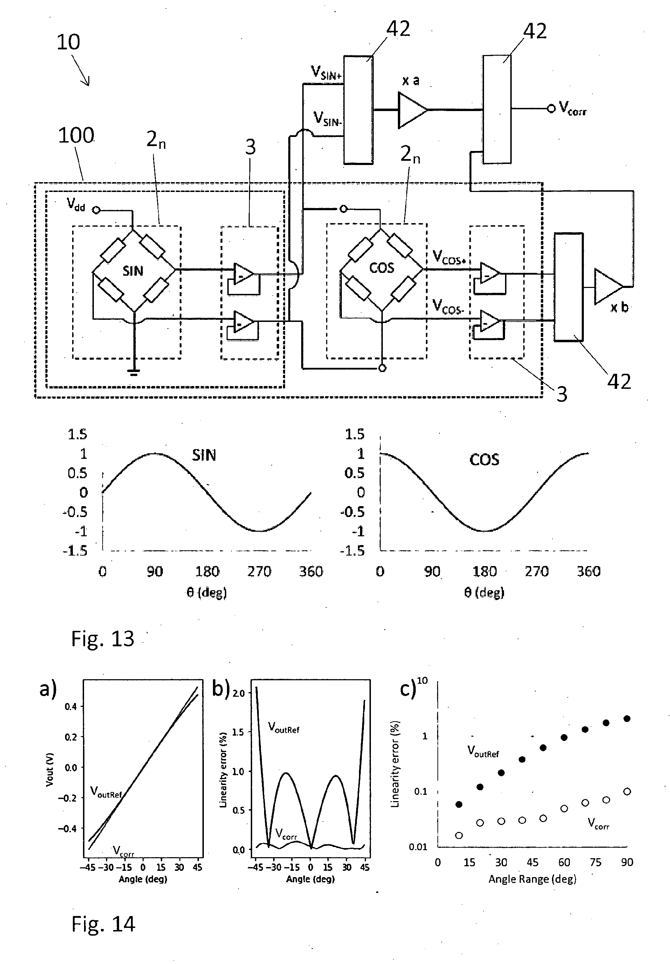

According to this embodiment, Fig. 13 illustrates a 2D magnetic sensor device 10 with a linearized response with respect to the magnetic field orientation angle $\theta$. The magnetic sensor device 10 comprises a cascade magnetic sensor circuit 100 with two 2D magnetic sensors $2_n$ connected in cascade, where the first 2D magnetic sensor is used as a reference magnetic sensor.

At high level, the first 2D magnetic sensor $2_{n=1}$ or $2_{Ref}$ follows a response with respect to the orientation $\theta$ of the external magnetic field vector H with respect to a certain predefined axis in a coordinate system. described by Eq. 16:

$$V_{outRef} = V_{SIN} = V_{dd\_SIN} \cdot A_{SIN} \cdot sin\theta \qquad \text{Eq. 16.}$$

Similarly, the second 2D magnetic sensor $2_{n=2}$ follows a response with respect to the orientation $\theta$ of the external magnetic field vector H with respect to a certain predefined axis in a coordinate system described by Eq. 17:

$$V_{COS} = V_{dd\_COS} \cdot A_{COS} \cdot cos\theta \qquad \text{Eq. 17,}$$

where $V_{dd\_SIN}$ and $V_{dd\_COS}$ are the bias voltage submitted to both magnetic sensors and $A_{SIN}$ and Acos are the normalized amplitude voltages of both signals. Note the normalized output voltage for both sensors are therefore:

$$V_{s\_SIN} = A_{SIN} \cdot sin\theta \qquad \text{Eq. 18a}$$

$$V_{s\_COS} = A_{COS} \cdot cos\theta \qquad \text{Eq. 18b.}$$

With this cascade configuration the output voltage of the first 2D magnetic sensor ($V_{SIN}$) is used as the input bias voltage of the second 2D magnetic sensor $2_2$. Therefore, the same bias voltage submitted to both magnetic sensors (Vdd $=V_{dd\_SIN} = V_{dd\_COS}$) considering similar normalized amplitude voltages (A = $A_{SIN}$ = Acos), the cascade output voltage of this system will be:

$$V_{outCascade} = = V_{dd} \cdot A^2 \cdot sin\theta \cdot cos\theta \qquad \text{Eq. 19.}$$

By considering Eq.16 and Eq.19 in Eq.11, the corrected output voltage of this magnetic sensor device 10 is:

$$V_{corr} = V_{dd} \cdot A \cdot (a \cdot sin\theta - b \cdot sin\theta \cdot cos\theta) \qquad \text{Eq.20.}$$

By adjusting the values of parameters a and b, the corrected output voltage $V_{corr}$ can show, up to a certain angle range, a linear dependence with respect to the orientation $\theta$ of the external magnetic field vector H.

Fig. 14a shows both the reference output voltage $V_{outRef}$ and the corrected output voltage $V_{corr}$ with respect to the magnetic field orientation $\theta$ between [-45°, 45°]. For this case, a ~ 1.38 and b ~ 0.38/A. Linearity error with respect to the magnetic field orientation $\theta$ at this angle range for both $V_{outRef}$ and $V_{corr}$ is shown in Fig.14b. Note that linearity error of $V_{corr}$ is ~ 0.1 % at this angular range, which is x 20 smaller than $V_{outRef}$. Fig. 14c, shows the impact of angle range on linearity error for both the reference 2D magnetic sensor ($V_{outRef}$) and the proposed magnetic sensor device 10 ($V_{corr}$). Typically, a 2D magnetic sensor shows a linearity error ~ 0.1 % only for angular ranges between [-10°, 10°] and linearity error increases dramatically with angular range. On the other hand, magnetic sensor device 10 enables to obtain a similar linearity error by increasing the working angular range by about 4.5 times.

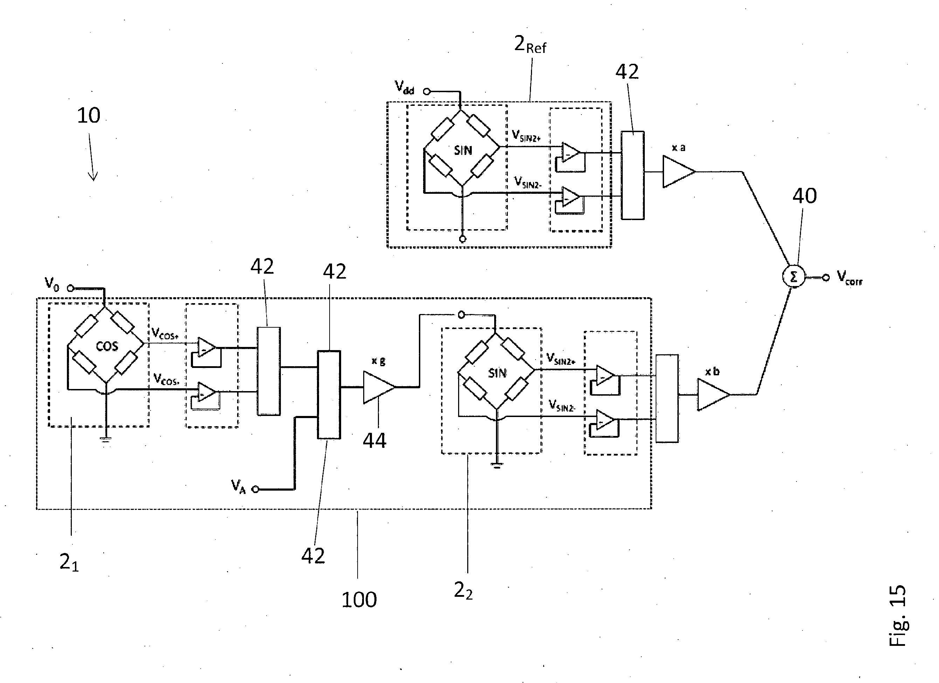

According to another embodiment, Fig. 15 illustrates an alternative 2D magnetic sensor device 10 with a linearized response with respect to the magnetic field orientation $\theta$. In this case, however, the reference magnetic sensor $2_{Ref}$ is not part of the cascade magnetic sensor circuit 100 as in Fig.14. Note, also that between two stages of the cascade magnetic sensor circuit 100 a differential amplifier 42 and an amplification 44 is used (amplification stage g).

Different other configurations of the 2D magnetic sensor device 10 described in Fig. 14 can be considered in order to obtain a similar improvement of the linearity error. The cascade sensor circuit 100 of Fig. 15 is configured so the output voltage $V_{out1}$ of the first magnetic sensors $2_1$ of the cascade circuit 100 is subtracted from an additional voltage signal $V_{add}$ and then amplified by factor g. This signal is then used as the bias voltage of the 2nd magnetic sensor $2_2$ $V_{dd\_2}$ :

$$V_{dd\_2} = (V_{add} - V_{out1}) \cdot g \qquad\qquad \text{Eq. 21,}$$

and to generate a cascade output voltage:

$$V_{outCascade} = \left(V_{add} - V_{dd} \cdot v_{s\_1}\right) \cdot g \cdot v_{s\_2} \qquad\qquad \text{Eq. 22.}$$

Considering the SIN and COS response of the first and second magnetic sensor of the cascade sensor circuit 100 of Fig. 15, The corrected output voltage of this magnetic sensor device 10 can then be written as:

$$V_{corr} = a \cdot V_{dd} \cdot A \cdot sin\theta + b \cdot (V_{add} - V_0 \cdot A \cdot cos\theta) \cdot g \cdot A \cdot sin\theta \qquad \text{Eq. 24a,}$$

where $V_{add}$ is the additional bias voltage used at the output of the first magnetic sensor and g is an amplification factor.

By adjusting the values of parameters a, b and amplification factor g as well as input bias voltages $V_0$ and $V_A$ as: a ~ 1, $V_0$ ~ $V_{dd}$, $V_{add}$ ~ $A \cdot V_{dd}$ and $b \cdot g$~ 0.38/(A) the corrected output voltage $V_{corr}$ can show, up to a certain angle range, a similar linear dependence with respect to the orientation $\theta$ of the external magnetic field vector H than the previous embodiment shown in Fig. 14.

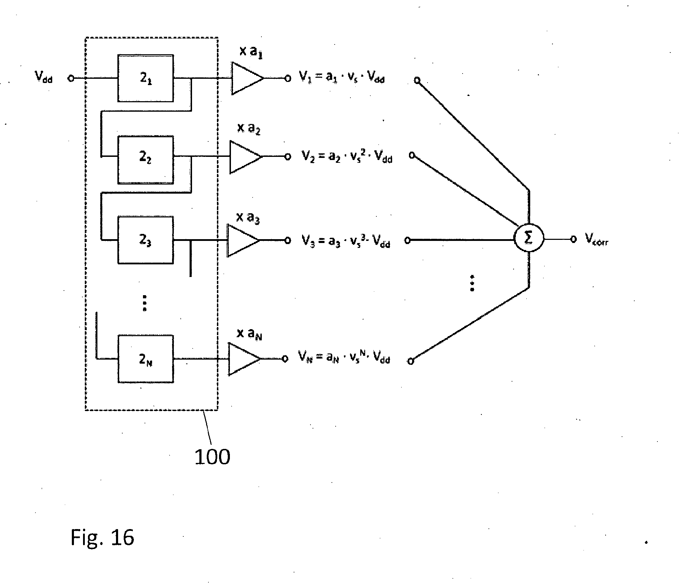

Finally, the cascade sensor circuit 100 can be configured not only to correct the high order component of a reference output voltage $V_{outRef}$ but also to generate any desired polynomial output voltage response that might be useful for other purposes as sketched in Fig. 16.

For example, the cascade sensor circuit 100 can comprise N magnetic sensors $2_n$, wherein N equal to or greater than 2, and include a first magnetic sensor $2_1$ and at least another magnetic sensor $2_n$ electrically connected in cascade with each other. The first magnetic sensor $2_1$ can be configured to generate a first output voltage $V_{out1}$ dependent on the external magnetic field vector H when submitted to an input bias voltage $V_{dd}$. The first output voltage $V_{out1}$ of the first magnetic sensor $2_1$ can be used as a bias voltage of the next magnetic sensor $2_2$. The N-1 output voltage $V_{outN-1}$ of the N-1 magnetic sensor $2_{N-1}$ can be used to bias voltage the N magnetic sensor $2_N$. The output of each magnetic sensor $2_n$ is split so one part is used to biased the next magnetic sensor will the other part is amplified by a factor $g_n$ leading to a signal:

$$V_n = g_n \cdot V_{outn} \qquad\qquad \text{Eq. 23.}$$

The cascade sensor circuit is configured to generate an output voltage $V_{outCascade}$ determined by:

$$V_{outCascade} = \sum_{n=1}^{N} V_n = \sum_{n=1}^{N} a_n \cdot V_{outn} \qquad \text{Eq. 24,}$$

where $V_{outn}$ is the output voltage of the $n^{th}$ magnetic field sensor of the cascade sensor circuit and $a_n$ is an amplification factor (or coefficient) independent of the external magnetic field vector H and can be either positive or negative.

Reference numbers and symbols

| | |
|---|---|
| 10 | magnetic sensor device |
| 100 | cascade sensing circuit |
| 2 | magnetic sensor |
| $2_1$ | first magnetic sensor |
| $2_n$ | $n^{th}$ magnetic sensor |
| $2_R$ | reference magnetic sensor |
| 20 | magnetic sensing element |
| 3 | amplifier buffer |
| 40 | summing circuit |
| 42 | differential amplifier |
| 44 | amplification |
| $\theta$ | magnetic field orientation angle |
| H | external magnetic field vector |
| N | number of magnetic sensors |
| $V_0$ | input bias voltage |
| $V_{corr}$ | corrected output voltage |
| $V_{dd}$ | input bias voltage, input |
| $V_{out}$ | output voltage |
| $V_{out1}$ | first output voltage |
| $V_{outn}$ | output voltage |
| $V_{outRef}$ | reference output voltage |
| $V_{outCascade}$ | cascade output voltage |
| $V_{out1(H)}$ | normalized output voltage |

**Claims**

1. A cascade magnetic sensor circuit (100) comprising N magnetic sensors ($2_n$), each magnetic sensors ($2_n$) generating an output voltage ($V_{outn}$), wherein N equal to or greater than 2, wherein the magnetic sensors ($2_n$) are electrically connected in cascade with each other;

   wherein the output voltage ($V_{outn}$) of the $n^{th}$ magnetic sensors ($2_n$) is proportional to an input bias voltage ($V_{dd\_n}$) of the $n^{th}$ magnetic sensor ($2_n$) and to a normalized output voltage ($v_{s\_n}(H)$) of the $n^{th}$ magnetic sensor ($2_n$) depending on the external magnetic field vector (H):

$$V_{outn} = v_{s\_n}(H) \cdot V_{dd\_n}$$

   wherein the output voltage ($V_{outn}$) of one of the $n^{th}$ magnetic sensors ($2_n$) supplies the input bias voltage ($V_{dd\_n+1}$) of the $(n+1)^{th}$ magnetic sensor ($2_{n+1}$).

2. The cascade magnetic sensor circuit according to claim 1,

   wherein the cascade sensor circuit (100) is configured to generate an output voltage ($V_{outCascade}$):

$$V_{outCascade} = V_{dd} \cdot \prod_{n=1}^{N} v_{s\_n}(H),$$

where $v_{s\_n}$ is the normalized output voltage of the $n^{th}$ magnetic sensor of the cascade magnetic sensor circuit and $V_{dd}$ is the input bias voltage of the first magnetic sensor of the cascade magnetic sensor circuit.

3. The cascade magnetic sensor circuit according to claim 1 or 2, comprising a first magnetic sensor ($2_1$) cascade connected to at least another magnetic sensor ($2_n$);

the normalized output voltage ($v_{s\_n}(H)$) of each magnetic sensor ($2_n$) having a substantially identical dependence on the external magnetic field vector (H); and
wherein the cascade magnetic sensor circuit (100) generates an output voltage ($V_{outCascade}$) that is proportional to a degree N with respect to the normalized output voltage ($v_{s\_1}(H)$) of the first magnetic sensor ($2_1$) and to the input bias voltage ($V_{dd}$) inputted to the first magnetic sensor ($v_{out1}$):

$$V_{outCascade} = V_{dd} \cdot v_{s\_1}^{N}(H).$$

4. The cascade magnetic sensor circuit according to claim 2 or 4, comprising an amplification (g) stage at the output of at least 1 of the N magnetic sensors of the cascade circuit, wherein the cascade sensor circuit (100) is configured to generate an output voltage ($V_{outCascade}$):

$$V_{outCascade} = V_{dd} \cdot \prod_{n=1}^{N} g_n \cdot v_{s\_n}(H).$$

5. The cascade magnetic sensor circuit according to claim 4, wherein an additional positive or negative voltage signal ($V_{add}$) is added to the output voltage $V_{outn}$ of at least one of the magnetic sensors ($2_n$) of the cascade circuit (100) before amplification stage so the cascade sensor circuit is configured to generate an output voltage ($V_{outCascade}$).

6. The cascade magnetic sensor circuit according to any one of claims 1 to 5, wherein all magnetic sensors comprises four magnetic sensing elements (20) arranged in a full-bridge circuit.

7. The cascade magnetic sensor circuit according to claim 6, wherein the magnetic sensing element (20) comprises at least one magnetoresistive element, such as a magnetic tunnel junction.

8. The cascade magnetic sensor circuit according to claim 1,

wherein the cascade sensor circuit is configured to generate an output voltage ($V_{outCascade}$) determined by:

$$V_{outCascade} = \sum_{n=1}^{N} a_n \cdot V_{outn},$$

where the $a_n$ coefficients are independent of the external magnetic field vector (H) and can be either positive or negative.

9. The cascade magnetic sensor circuit according to any of claims 1 to 8, comprising a voltage buffer (3) at the output of each magnetic sensor of the cascade sensor circuit (100).

10. A magnetic sensor device (10) for sensing an external magnetic field vector (H) and comprising the cascade magnetic sensor circuit (100) according to any one of claims 1 to 9 and at least one reference magnetic field sensor ($2_{Ref}$);

wherein a corrected output voltage ($V_{corr}$) of the magnetic sensor device is determined by:

$$V_{corr} = a \cdot V_{outRef} + b \cdot V_{outCascade},$$

where a and b are correction parameters independent of the external magnetic field vector (H), $V_{outRef}$ is a reference output voltage generated by at least one reference magnetic sensor, the corrected output voltage ($V_{corr}$) having improved linearity compared to the reference output voltage ($V_{outRef}$), and $V_{outCascade}$ is the cascade output voltage of the cascade magnetic sensing circuit (100).

11. The magnetic sensor device according to claim 10,

wherein the cascade output voltage ($V_{outCascade}$) of the cascade magnetic sensing circuit (100) is electrically connected to the reference output voltage ($V_{outRef}$) of the reference magnetic sensor ($2_{Ref}$) via a summing circuit (40) configured to sum the cascade output voltage ($V_{outCascade}$) to the reference output voltage ($V_{outRef}$); and wherein a corrected output voltage ($V_{corr}$) of the magnetic sensor device is determined by:

$$V_{corr} = a \cdot V_{outRef} + b \cdot V_{outCascade}.$$

12. The magnetic sensor device according to claim 11,
wherein the cascade output voltage ($V_{outCascade}$) of the cascade magnetic sensing circuit (100) is electrically connected to the reference output voltage ($V_{outRef}$) of the reference magnetic sensor ($2_{Ref}$) via a differential amplifier circuit (42) configured to subtract the cascade output voltage ($V_{outCascade}$) to the reference output voltage ($V_{outRef}$).

13. The magnetic sensor device according to any one of claims 10 to 12,
wherein the reference output voltage ($V_{outRef}$) is generated by least one of the magnetic sensors of the cascade magnetic sensing circuit (100).

14. The magnetic sensor device according to any one of claims 10 to 12,
wherein the reference magnetic sensor ($2_{Ref}$) is an external magnetic sensor element from the cascade magnetic circuit (100).

15. The magnetic sensor device according to any one of claims 10 to 14,
wherein the reference magnetic sensor ($2_{Ref}$) comprises four magnetic sensing elements (20) arranged in a full-bridge circuit.

16. The magnetic sensor device according to any one of claims 10 to 15,
comprising a voltage buffer (3) at the output of each magnetic sensor of the magnetic sensor device 10

$V_{out} = V_{out+} - V_{out-}$

Fig. 1

Fig. 2

$$V_{out3} = V_{dd3} \cdot v_s = (V_{out2+} - V_{out2-}) \cdot v_s = V_{dd} \cdot v_s^3$$

Fig. 3

$V_{out\_1} = V_{dd} \cdot v_s$      $V_{out\_2} = V_{dd} \cdot v_s^2$    ...    $V_{out\_N-1} = V_{dd} \cdot v_s^{N-1}$      $V_{out\_N} = V_{dd} \cdot v_s^N$

100, 10

Fig. 4

Fig. 5

Fig. 6

Fig. 7

Fig. 8

Fig. 9

Fig. 10

Fig. 11

Fig. 12

Fig. 13

Fig. 14

Fig. 15

$$V_{dd} \quad 2_1 \quad \times a_1 \quad V_1 = a_1 \cdot v_s \cdot V_{dd}$$

$$2_2 \quad \times a_2 \quad V_2 = a_2 \cdot v_s^2 \cdot V_{dd}$$

$$2_3 \quad \times a_3 \quad V_3 = a_3 \cdot v_s^3 \cdot V_{dd}$$

$$2_N \quad \times a_N \quad V_N = a_N \cdot v_s^N \cdot V_{dd}$$

$$\Sigma \quad V_{corr}$$

100

Fig. 16

Europäisches
Patentamt

European
Patent Office

Office européen
des brevets

# EUROPEAN SEARCH REPORT

Application Number

EP 22 31 5165

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DE 10 2006 025902 A1 (BOSCH GMBH ROBERT [DE]) 6 December 2007 (2007-12-06) | 1-3,6-16 | INV. G01R33/00 G01R33/09 |
| Y | * paragraphs [0007] - [0033]; figures 1-5 * | 4,5 | |
| X | EP 2 818 884 A1 (JIANGSU MULTIDIMENSION TECH CO [CN]) 31 December 2014 (2014-12-31) | 1-3,8-16 | |
| Y | * paragraphs [0056] - [0060]; figure 5 * | 4,5 | |
| A | | 6,7 | |
| Y | WO 2022/144621 A1 (CROCUS TECH INC [US]; CROCUS TECHNOLOGY SA [FR]) 7 July 2022 (2022-07-07) * figures 19-24 * | 4,5 | |
| A | BRAUN F ET AL: "A Chopper Stabilized Biasing Circuit Suitable for Cascaded Wheatstone-Bridge-Like Sensors", IEEE TRANSACTIONS ON CIRCUITS AND SYSTEMS PART I: REGULAR PAPERS, IEEE SERVICE CENTER, NEW YORK, NY, US, vol. 52, no. 8, 1 August 2005 (2005-08-01) , pages 1653-1665, XP011137708, ISSN: 1057-7122, DOI: 10.1109/TCSI.2005.852022 * the whole document * | 1-16 | TECHNICAL FIELDS SEARCHED (IPC)<br><br>G01R |

The present search report has been drawn up for all claims

| Place of search | Date of completion of the search | Examiner |
|---|---|---|
| Munich | 5 January 2023 | Philipp, Peter |

EPO FORM 1503 03.82 (P04C01)

## ANNEX TO THE EUROPEAN SEARCH REPORT
## ON EUROPEAN PATENT APPLICATION NO.

EP 22 31 5165

This annex lists the patent family members relating to the patent documents cited in the above-mentioned European search report.
The members are as contained in the European Patent Office EDP file on
The European Patent Office is in no way liable for these particulars which are merely given for the purpose of information.

05-01-2023

| Patent document cited in search report | Publication date | Patent family member(s) | | Publication date |
|---|---|---|---|---|
| DE 102006025902 A1 | 06-12-2007 | NONE | | |
| EP 2818884 A1 | 31-12-2014 | CN | 102565727 A | 11-07-2012 |
| | | EP | 2818884 A1 | 31-12-2014 |
| | | JP | 6420665 B2 | 07-11-2018 |
| | | JP | 2015513667 A | 14-05-2015 |
| | | US | 2015091560 A1 | 02-04-2015 |
| | | WO | 2013123873 A1 | 29-08-2013 |
| WO 2022144621 A1 | 07-07-2022 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2021IB60743 A